# EUROPEAN PATENT SPECIFICATION

(11) **EP 4 084 057 B1**
(45) Date of publication and mention of the grant of the patent: **29.01.2025**
(21) Application number: 20904365.2
(22) Date of filing: 24.02.2020
(51) Int. Cl.: H01L 23/043, H01L 23/051, H01L 23/00, H01L 25/07, H01L 25/11

(54) **CRIMPING-TYPE IGBT MODULE AND POWER SEMICONDUCTOR DEVICE**
CRIMP-IGBT-MODUL UND LEISTUNGSHALBLEITERBAUELEMENT
MODULE IGBT DE TYPE À SERTISSAGE ET DISPOSITIF À SEMI-CONDUCTEUR DE PUISSANCE

(30) Priority: 27.12.2019 CN 201911381706
(43) Date of publication of application: 02.11.2022
(73) Proprietor: Zhuzhou CRRC Times Semiconductor Co., Ltd., Zhuzhou, Hunan 412005 (CN)
(72) Inventor: SHI, Tingchang, Zhuzhou, Hunan 412005 (CN); CHANG, Guiqin, Zhuzhou, Hunan 412005 (CN); LI, Han, Zhuzhou, Hunan 412005 (CN); PENG, Yongdian, Zhuzhou, Hunan 412005 (CN); LUO, Haihui, Zhuzhou, Hunan 412005 (CN); DONG, Guozhong, Zhuzhou, Hunan 412005 (CN); KANG, Qiang, Zhuzhou, Hunan 412005 (CN); ZHANG, Wenhao, Zhuzhou, Hunan 412005 (CN); WANG, Yuqi, Zhuzhou, Hunan 412005 (CN)
(74) Representative: Petraz, Gilberto Luigi
(86) International application number: PCT/CN2020/076428
(87) International publication number: WO 2021/128562

(56) References cited:
- CN-A- 103 579 165
- CN-A- 106 483 441
- CN-A- 108 281 406
- JP-A- 2005 101 489
- US-A- 5 874 774
- US-A1- 2004 021 149
- US-A1- 2004 207 070

## Description

### Field of the Invention

The present invention relates to the technical field of power semiconductor devices, and in particular to a crimping-type IGBT module and a power semiconductor device.

### Background of the Invention

For most of the existing crimping-type IGBT modules, a chip is stressed by means of a spring or a disc spring. However, there is a problem of uneven stress of chips. For example, in the crimping-type semiconductor module disclosed in Chinese patent application No. 201410661590.2 and entitled "Crimping-type semiconductor module", a chip is stressed by means of the deformation of a spring, and the displacement during a deformation process needs to be compensated by a deformation buffer structure of a tube housing. During the process of repeated deformation, the deformation buffer structure of the tube housing is prone to producing a stress, which then causes the cracking of a metal welding layer of the tube housing and the gas leakage of a module, and thus damages the internal environment of the module, resulting in a reliability decrease or even a failure of the device.

For another example, in a large-power semiconductor module disclosed in Chinese patent publication CN100355070C and entitled "Large-power semiconductor module", the stress of a chip unit is ensured by means of the structural deformation of a disc spring, and the movement of modules is realized by means of the displacement produced by the deformation of the disc spring. The limitations lie in that the modules can only move in a single direction, there is a difference in the actual displacement of the various modules due to the structural size precision of the various modules being inconsistent, which directly causes the stress difference of the chip unit, and thus affects the overall property of the modules. Moreover, a conductive bypass sheet is arranged around the disc spring, and the conductive bypass thin sheet needs to deform synchronously with the deformation of the disc spring. The characteristic of a bypass thin sheet being capable of normally deforming should be ensured, and therefore, it is not possible to make the bypass thin sheet big and thick, which directly limits the through-flow capability of the bypass thin sheet. In addition, when the modules are designed, it is necessary to reserve a certain deformation space for the bypass thin sheet, which also results in the overall volume of the modules being larger, and is inconducive to the increase of the power density of the modules.

### Summary of the Invention

For the above-mentioned problems in the existing technique, the present application provides a crimping-type IGBT module and a power semiconductor device, in order to solve some or all of the above-mentioned problems.

In a first aspect, the application provides a crimping-type IGBT module according to claim 1, including a plurality of sub-modules capable of moving up and down relative to a tube housing. Each of the sub-modules includes:
a conductive substrate and a conductive cover plate capable of being accommodated in the tube housing or respectively extending out of a lower surface and an upper surface of the tube housing;
a plurality of chips juxtaposed and spaced apart on the conductive substrate;
a pressure-bearing member capable of moving up and down relative to the tube housing, so that same is accommodated in the tube housing or extends out of the lower surface of the tube housing;
a bypass busbar arranged above the chips, an upper portion thereof abutting against an upper surface of the pressure-bearing member; and
an elastic member arranged between the bypass busbar and the conductive cover plate.

When a press-fitting force is not greater than an elastic force provided by the elastic member, the conductive cover plate extends out of the upper surface of the tube housing, both the conductive substrate and the pressure-bearing member extend out of the lower surface of the tube housing, and a lower surface of the conductive substrate is flush with the lower surface of the pressure-bearing member.

When the press-fitting force is greater than the elastic force provided by the elastic member, both the lower surface of the conductive substrate and the lower surface of the pressure-bearing member are flush with the lower surface of the tube housing, and an upper surface of the conductive cover plate is flush with the upper surface of the tube housing.

In one implementation according to the first aspect, each of the sub-modules further includes a buffer block. The buffer block is arranged between a module cover plate and the pressure-bearing member, and the buffer block is configured for buffering the pressure-bearing member when the pressure-bearing member moves upwards relative to the tube housing.

In one implementation according to the first aspect, each of the sub-modules further includes a conductive buffer pad arranged between the chips and the bypass busbar, the conductive buffer pad being configured for ensuring the reliability of electrical conduction between the chips and the bypass busbar.

In one implementation according to the first aspect, an expansion coefficient of the conductive buffer pad and a thermal expansion coefficient of the conductive substrate match a thermal coefficient of the chips, so as to avoid a defect occurring on a contact surface therebetween.

In one implementation according to the first aspect, the chips and the conductive substrate, as well as the chips and the conductive buffer pad are connected by means of welding or silver sintering.

In one implementation according to the first aspect, the conductive buffer pad and the conductive substrate are both made of molybdenum or a molybdenum-copper alloy.

In one implementation according to the first aspect, each of the sub-modules further includes a gate output probe, which is configured for outputting gate signals of the plurality of chips in parallel.

In one implementation according to the first aspect, each of the sub-modules further includes a side frame. A bottom face of the side frame is connected to edges of an upper surface of the conductive substrate in a sealed manner, so as to form a cavity with a sealed bottom portion and an open upper portion. The cavity is potted with silica gel, so as to form an insulation distance between the conductive substrate and the conductive buffer pad.

In one implementation according to the first aspect, each of the sub-modules further includes a pressure-bearing pad, which is arranged between the bypass busbar and the elastic member and is configured for buffering pressure transfer between the bypass busbar and the elastic member, so that the intensity of contact pressure between the chips is consistent.

In one implementation according to the first aspect, a first step is formed on an outer wall face of the pressure-bearing member, and a second step fitted with the first step is formed on an inner wall face of the tube housing, so as to limit a stroke of downward movement of the pressure-bearing member.

In a second aspect, the application provides a power semiconductor device according to claim 11, including the crimping-type IGBT module according to the first aspect.

Compared with the prior art, the application has the following advantages.
1) With regard to the crimping-type IGBT module of the application, the stress of a chip completely depends on a deformation amount ΔH of an elastic member, and is not affected by a variation of a press-fitting force, such that the pressure uniformity between the chips can be completely ensured, thereby also ensuring the reliability of the application of the IGBT module.
2) With regard to the crimping-type IGBT module of the application, the sub-module can move in two directions on the basis of a lower surface and an upper surface of a tube housing, the requirement for size tolerance precision is relatively low, and a deformation amount of a spring can greatly compensate the tolerance of structure members in a longitudinal direction (i.e., In a height direction of the tube housing), thereby ensuring the pressure uniformity of the chips.
3) A current bypass structure does not change along with the deformation of the spring, and the thickness of a bypass busbar can be adjusted according to actual requirements, such that the through-flow capability is stronger.
4) Upper and lower faces of the chip are respectively connected to Mo or Mo-Cu alloy, a material expansion coefficient of which is close to that of the chip, by means of welding or a silver sintering process, such that the interface contact is more reliable, and the product property is greatly improved.
5) A pressure-bearing member can move up and down relative to the tube housing, thereby improving the flexibility of the assembly; and the thickness tolerance of various structure members in a longitudinal direction is compensated by means of displacement, thereby ensuring the reliability of the crimping connection between a conductive cover plate and the bypass busbar.

The above-mentioned features can be combined in any suitable manner or be replaced by equivalent features, as long as the objective of the invention can be achieved.

### Brief Description of the Drawings

The invention will be described in more details below based on embodiments and referring to the accompanying drawings, wherein
Fig. 1 shows a schematic diagram of the circuit topology of each sub-module of a crimping-type IGBT module according to the application;
Fig. 2 shows a schematic diagram of the circuit topology of six parallel sub-modules of the crimping-type IGBT module according to the application;
Fig. 3 shows a top view of the crimping-type IGBT module according to the application;
Fig. 4 shows a cross-sectional view of the crimping-type IGBT module according to the application;
Fig. 5 shows a cross-sectional view of each sub-module of the crimping-type IGBT module according to the application in a free state;
Fig. 6 shows an exploded view of each sub-module of the crimping-type IGBT module according to the application; and
Fig. 7 and Fig. 8 respectively show stress schematic diagrams of each sub-module of the crimping-type IGBT module according to the application before press-fitting and after press-fitting.

In the accompanying drawings, the same component uses the same reference sign. The accompanying drawings are not drawn to the same scale.

### Detailed Description of the Embodiments

The invention will be further described below in conjunction with the accompanying drawings.

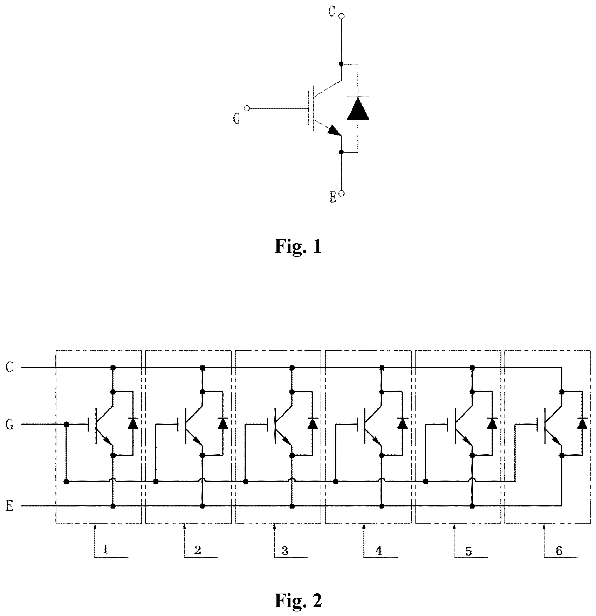

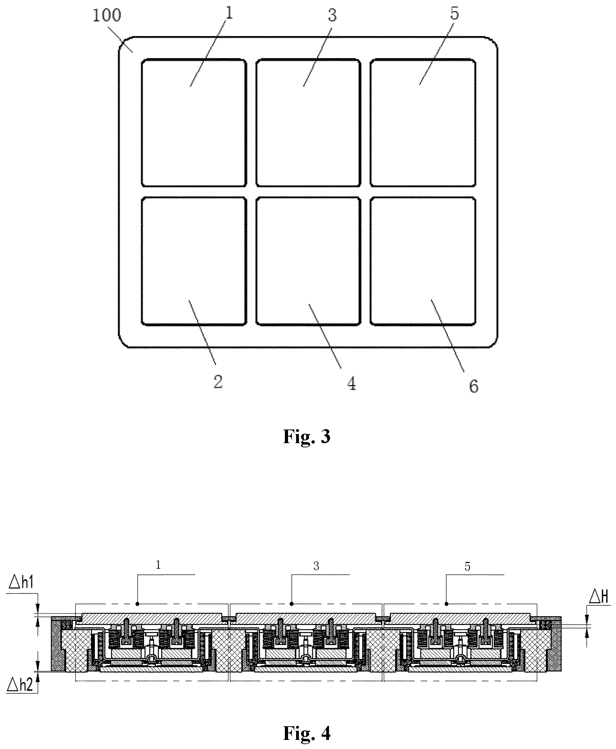

As shown in Fig. 3, the application provides a crimping-type IGBT module 100, including a plurality of sub-modules in a parallel layout. The sub-modules can move up and down relative to a tube housing (including a module outer frame 17 and a module cover plate 18). The circuit topology graph of each sub-module is as shown in Fig. 1. In Fig. 1, C represents an IGBT collector, E represents an IGBT emitter, and G represents an IGBT gate. In an IGBT, the functions of a power switch and electric energy conversion are realized by means of a gate drive signal.

In order to realize a specified power output, the crimping-type IGBT module preferably includes six sub-modules (1, 2, 3, 4, 5, 6) (as shown in Figs. 3 and 4), each sub-module using a topology circuit as shown in Fig. 1, where internal gate signals G are aggregated and output by a PCB, and a parallel topology circuit is as shown in Fig. 2.

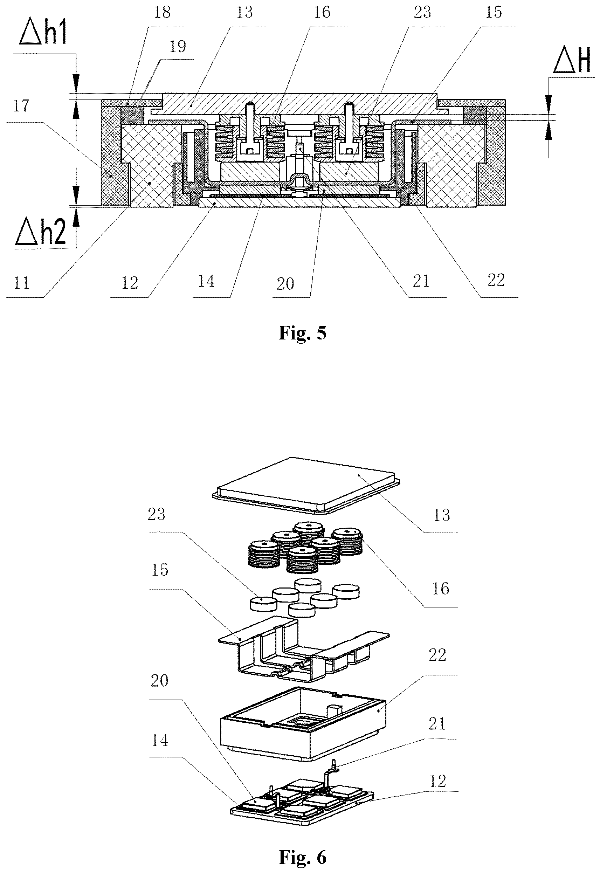

In order to more clearly illustrate the structure of the sub-module in details, with reference to Figs. 5 and 6, one sub-module 1 therein is taken as an example for illustration. In Figs. 5 and 6, the sub-module 1 includes a pressure-bearing member 11, a conductive substrate 12, a conductive cover plate 13, a plurality of chips 14, a bypass busbar 15 and an elastic member 16.

The pressure-bearing member 11 can move up and down relative to the tube housing, so that a lower surface of the pressure-bearing member can extend out of a lower surface of the tube housing or be accommodated in the tube housing. As shown in Fig. 5, a first step is formed on an outer wall face of the pressure-bearing member 11, a second step fitted with the first step is formed on an inner wall face of tube housing, and the first step can abut against the second step, so as to limit a stroke of downward movement of the pressure-bearing member 11.

The conductive substrate 12 and the conductive cover plate 13 can be accommodated in the tube housing or respectively extend out of the lower surface and an upper surface of the tube housing. The chips 14 are juxtaposed and spaced apart on the conductive substrate 12.

The bypass busbar 15 is arranged above the chips 14, with an upper part abutting against an upper surface of the pressure-bearing member 11. When the conductive cover plate 13 moves downwards, the pressure-bearing member 11 can ensure the reliability of press-fitting between the conductive cover plate 13 and the bypass busbar 15.

The elastic member 16 is arranged between the bypass busbar 15 and the conductive cover plate 13. When a press-fitting force is not greater than an elastic force provided by the elastic member 16, the conductive cover plate 13 extends out of the upper surface of the tube housing (i.e., an upper surface of the module cover plate 18), both the conductive substrate 12 and the pressure-bearing member 11 extend out of the lower surface of the tube housing (i.e., a lower surface of the module outer frame 17), and a lower surface of the conductive substrate 12 is flush with the lower surface of the pressure-bearing member 11. When the pressure assembling force is greater than the elastic force provided by the elastic member 16, the conductive substrate 12, the conductive cover plate 13 and the pressure-bearing member 11 are all accommodated in the tube housing, and the lower surfaces of the conductive substrate 12 and the pressure-bearing member 11 are flush with the lower surface of the tube housing (i.e., the lower surface of the module outer frame), and the upper surface of the conductive cover plate 13 is flush with the upper surface of the tube housing (i.e., the upper surface of the module cover plate).

In the above-mentioned structure, when the sub-module 1 is in the free state, the conductive cover plate 13 (i.e., an emitter plate) protrudes out of a module upper mesa (i.e., the upper surface of the module cover plate 18) by Δh1, the conductive substrate 12 (i.e., the collector plate) protrudes a module lower mesa (i.e., the lower surface of the module outer frame 17) by Δh2, and the spacing between the lower surface of the conductive cover plate 13 and the bypass busbar 15 is ΔH. Since the conductive cover plate 13 (i.e., the emitter plate) and the bypass busbar are in a turned-on state, when the IGBT module is not subjected to an external press-fitting force, the conductive cover plate 13 (i.e., the emitter plate) and the conductive substrate 12 (i.e., the collector plate) are in a turned-off state. When the IGBT module is subjected to a press-fitting force (the press-fitting force needs to be greater than the elastic force of the elastic member 16), the elastic member deforms, the conductive cover plate 13 is compressed by Δh1, and the conductive substrate 12 is compressed by Δh2, so that the lower surface of the conductive cover plate 13 is in press-fitting contact with the bypass busbar 15, thereby ensuring the conductive cover plate 13 (i.e., the emitter plate) and the conductive substrate 12 (i.e., the collector plate) of the module are in a working preparation state (a state in which same can work once same are powered on), that is, ΔH = Δh1 + Δh2. The above-mentioned process is a press-fitting process of one sub-module of the IGBT module according to the application.

When the sub-module in Fig. 5 is press-fitted, the pressure of the chips 14 completely depends on a deformation amount ΔH of the elastic member 16, and will not be affected by a variation of an external press-fitting force, such that the pressure uniformity of the chips 14 can be ensured.

In the embodiment as shown in Fig. 5, the bypass busbar 15 is configured to have a shape of an approximate inverted "Ω", with its bending parts all being bent at right angles. The bottom portion of the bypass busbar is arranged above a conductive buffer pad 20, and structures of two sides thereof abut against an upper surface of the pressure-bearing member 11. The bypass busbar 15, acting as a main path of an on-current, generally uses a copper sheet or an aluminum sheet, with a surface of the copper sheet or the aluminum sheet being plated with tin, nickel or silver. In the actual application, the thickness of the bypass busbar 15 can be flexibly adjusted according to the magnitude of a current. However, in the IGBT module disclosed in existing techniques, a bypass busbar must change along with the deformation of an elastic member, which limits that the bypass busbar must be thinned in order to satisfy a deformation capability.

Since the module outer frame 17 needs to have stronger anti-impact strength in addition to being used for the positioning and assembly of internal parts, and the anti-impact strength is greater than 1000 KJ/m². In the case of an unforeseen circumstance, for example, when the IGBT module fails and explodes, the module outer frame 17 can effectively prevent the internal parts from flying. The module outer frame 17 is preferably formed by injection molding of an enhanced composite fiber material.

The module cover plate 18 needs to be made of a material having a high comparative tracking index (CTI), great insulation performance and certain anti-pressure strength. The module cover plate 18 is preferably made of a polyester fiber material.

The pressure-bearing member 11, acting as a bearing structure of the conductive cover plate 13 and the bypass busbar 15, needs to have great anti-pressure strength in the height direction of the module outer frame 17 as the module outer frame 17, so as to effectively share excess external pressure other than a supporting force in an orientation of an effective deformation amount of a spring assembly, such that the material will not deform. The pressure-bearing member 11 needs to have greater anti-impact strength in the length direction of the module outer frame 17, such that in the case of an unforeseen circumstance, for example, when the IGBT module fails and explodes, same can effectively prevent the internal parts from flying. The pressure-bearing member is preferably formed by injection molding of an enhanced composite fiber material.

The conductive cover plate 13, acting as an electrical connection structure and a pressure-bearing structure for external pressure, needs to have great electrical and thermal conduction performance and meet a certain rigid requirement, and preferably uses copper, molybdenum or a copper-molybdenum alloy.

Preferably, as shown in Fig. 5, the sub-module 1 further includes a buffer block 19. The buffer block 19 is arranged between the module cover plate 18 and the pressure-bearing member 11, and the buffer block 19 is configured for buffering the pressure-bearing member 11 when the pressure-bearing member 11 moves up and down relative to the tube housing. The buffer block 19 is made of a flexible material such as sponge.

As shown in Fig. 5, the sub-module 1 further includes a conductive buffer pad 20 arranged between the chips 14 and the bypass busbar 15, and the conductive buffer pad is configured for ensuring the reliability of electrical conduction between the chips 14 and the bypass busbar 15.

The conductive substrate 12 and the conductive buffer pad 20 are respectively in contact with lower surfaces and upper surfaces of the chips 14, and the thermal expansion coefficient of the conductive substrate 12 and the thermal expansion coefficient of the conductive buffer pad 20 therefore need to match the thermal expansion coefficient of the chips 14 (generally being made of a silicon material), so that when the module is heated, the thermal expansion of the conductive substrate 12, the conductive buffer pad 20 and the chips 14 being consistent is ensured, thereby avoiding the defects on contact surfaces therebetween, such as a stress, a crack or a hole. The conductive substrate 12 and the conductive buffer pad 20 are preferably made of molybdenum or a copper-molybdenum alloy.

Preferably, the chips 14 and the conductive substrate 12 are connected by means of welding or silver sintering, and the chips 14 and the conductive buffer pad 20 can also be connected by means of welding or silver sintering, i.e., so-called "double-sided welding of a chip" or "double-sided silver sintering of a chip".

The elastic member 16 acts as a unique pressure applying structure of the chips 14, that is, the stress of the chips 14 is completely provided by an elastic force caused by deformation of the elastic member 16, and the material structure thereof is preferably a disc spring structure. In the actual application, the number and the combination method of disc springs can be flexibly configured according to the pressure of the chips. It will be understood that the elastic member 16 can also use the structure form such as a helical spring and a hydraulic spring, which can implement the same functions.

In the embodiment as shown in Fig. 5, the sub-module 1 further includes a gate output probe 21, which is configured for outputting gate signals from the plurality of chips in parallel. The gates of the chips 14 are aggregated by means of lead bonding, and then output signals by means of the gate output probe 21. Preferably, the gate output probe 21 is made of copper or beryllium-copper, and contact points are plated with gold.

In the embodiment as shown in Fig. 5, the sub-module further includes a side frame 22. A bottom face of the side frame 22 is connected to edges of an upper surface of the conductive substrate 12 in a sealed manner, so as to form a cavity with a sealed bottom portion and an open upper portion. The cavity is potted with adhesive, preferably with silica gel, so that there is an insulation distance between the conductive substrate 12 and the conductive buffer pad 20. The side frame 22 is preferably made of a polyester material, and the tolerable temperature of the polyester material is higher than 150°C.

In the embodiment as shown in Fig. 5, the sub-module 1 further includes a pressure-bearing pad 23, which is arranged between the bypass busbar 15 and the elastic member 16 and is configured for buffering pressure transfer between the bypass busbar 15 and the elastic member 16, so that the intensity of contact pressure between the chips 14 is consistent. The pressure-bearing pad 23 is preferably made of an aluminum material.

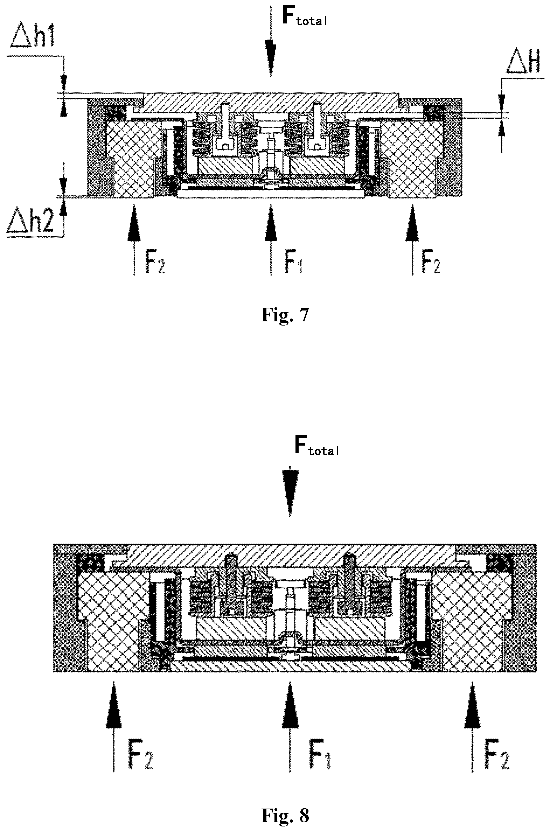

The stress condition of the sub-module according to the application when being press-fitted will be illustrated below in detail in conjunction with Figs. 7 and 8.

As shown in Fig. 7, when the module is subjected to a press-fitting force "Fₜₒₜₐₗ", a force decomposed into the module is divided into two components, one is "Fi", which is an applied force to the chips 4, and the other one is "F₂", which is an applied force to a pressure-bearing injection molded member 11. F₁ is provided by a counter-acting elastic force produced by a deformation amount ΔH of the elastic member 16, that is, F₁ = k * ΔH, where k is an elastic coefficient of the elastic member 16, and F₂ = Fₜₒₜₐₗ - F₁. Regardless of how the press-fitting force Fₜₒₜₐₗ changes, the force F1 applied to the chips 14 is fixed, and is only related to the elastic coefficient of the elastic member and not related to the press-fitting force Fₜₒₜₐₗ, thereby ensuring the reliability of the application of the module.

The crimping-type IGBT module according to the application can be applied to a power semiconductor device.

In summary, the application has the following advantages.
1) With regard to the crimping-type IGBT module of the application, the stress of a chip completely depends on a deformation amount ΔH of an elastic member, and is not affected by a variation of a press-fitting force, such that the pressure uniformity between the chips can be completely ensured, thereby also ensuring the reliability of the application of the IGBT module.
2) With regard to the crimping-type IGBT module of the application, the sub-module can move in two directions on the basis of a lower surface and an upper surface of a tube housing, the requirement for size tolerance precision is relatively low, and a deformation amount of a spring can greatly compensate the tolerance of structure members in a longitudinal direction (i.e., In a height direction of the tube housing), thereby ensuring the pressure uniformity of the chips.
3) A current bypass structure does not change along with the deformation of the spring, and the thickness of a bypass busbar can be adjusted according to actual requirements, such that the through-flow capability is stronger.
4) Upper and lower faces of the chip are respectively connected to Mo or Mo-Cu alloy, a material expansion coefficient of which is close to that of the chip, by means of welding or a silver sintering process, such that the interface contact is more reliable, and the product property is greatly improved.
5) A pressure-bearing member can move up and down relative to the tube housing, thereby improving the flexibility of the assembly; and the thickness tolerance of various structure members in a longitudinal direction is compensated by means of displacement, thereby ensuring the reliability of the crimping connection between a conductive cover plate and the bypass busbar.

In the description of the present invention, it is to be understood that the terms of "above", "below", "bottom", "top", "front", "rear", "inside", "outside", "left", "right", etc. indicating orientation or position relationships are based on the orientation or position relationship shown in the accompanying drawings and are intended to facilitate the description of the present invention and simplify the description only, rather than indicating or implying that an apparatus or element referred to must have a particular orientation or be constructed and operated in a particular orientation, and will not to be interpreted as limiting the invention.

Although the invention is described herein with reference to particular implementations, it should be understood that these embodiments are merely examples for the principle and application of the invention. Therefore, it should be understood that many modifications can be made to the exemplary embodiments, and other arrangements can be designed, without departing from the scope of the invention defined by the appended claims.

## Claims

1. A crimping-type IGBT module (100), comprising a plurality of sub-modules (1-6) capable of moving up and down relative to a tube housing (17, 18), wherein each of the sub-modules comprises:
a conductive substrate (12) and a conductive cover plate (13), which are capable of being accommodated in the tube housing or respectively extending out of a lower surface and an upper surface of the tube housing;
a plurality of chips (14), which are juxtaposed and spaced apart on the conductive substrate;
a pressure-bearing member (11), which is capable of being accommodated in the tube housing or extending out of the lower surface the tube housing;
a bypass busbar (15), which is arranged above the chips, and an upper portion of which abuts against an upper surface of the pressure-bearing member; and
an elastic member (16), which is arranged between the bypass busbar and the conductive cover plate, wherein
when a press-fitting force is not greater than an elastic force provided by the elastic member, the conductive cover plate extends out of the upper surface of the tube housing, both the conductive substrate and the pressure-bearing member extend out of the lower surface of the tube housing, and a lower surface of the conductive substrate is flush with the lower surface of the pressure-bearing member; and
when the press-fitting force is greater than the elastic force provided by the elastic member, both the lower surface of the conductive substrate and the lower surface of the pressure-bearing member are flush with the lower surface of the tube housing, and an upper surface of the conductive cover plate is flush with the upper surface of the tube housing.

2. The crimping-type IGBT module according to claim 1, wherein each of the sub-modules further comprises a buffer block (19), which is arranged between a module cover plate and the pressure-bearing member, and wherein the buffer block is configured for buffering the pressure-bearing member when the pressure-bearing member moves upwards relative to the tube housing.

3. The crimping-type IGBT module according to claim 1 or 2, wherein each of the sub-modules further comprises a conductive buffer pad (20), which is arranged between the chips and the bypass busbar, and wherein the conductive buffer pad is configured for ensuring the reliability of electrical conduction between the chips and the bypass busbar.

4. The crimping-type IGBT module according to any one of claims 3, wherein a thermal expansion coefficient of the conductive buffer pad and a thermal expansion coefficient of the conductive substrate match a thermal coefficient of the chips, so as to avoid a defect occurring on a contact surface therebetween.

5. The crimping-type IGBT module according to any one of claims 4, wherein the chips and the conductive substrate, as well as the chips and the conductive buffer pad are connected by means of welding or silver sintering.

6. The crimping-type IGBT module according to any one of claims 5, wherein the conductive buffer pad and the conductive substrate are both made of molybdenum or a molybdenum-copper alloy.

7. The crimping-type IGBT module according to any one of claims 1-6, wherein each of the sub-module further comprises a gate output probe (21), which is configured for outputting gate signals from the plurality of chips in parallel.

8. The crimping-type IGBT module according to any one of claims 1-7, wherein each of the sub-module further comprises a side frame (22), a bottom face of which is connected to edges of an upper surface of the conductive substrate in a sealed manner, so as to form a cavity with a sealed bottom portion and an open upper portion, and the cavity is potted with silica gel, so as to form an insulation distance between the conductive substrate and the conductive buffer pad.

9. The crimping-type IGBT module according to any one of claims 1-8, wherein each of the sub-modules further comprises a pressure-bearing pad (23), which is arranged between the bypass busbar and the elastic member, and wherein the pressure-bearing pad is configured for buffering pressure transfer between the bypass busbar and the elastic member, so that the intensity of contact pressure between the chips is consistent.

10. The crimping-type IGBT module according to any one of claims 1-9, wherein a first step is formed on an outer wall face of the pressure-bearing member, and a second step fitted with the first step is formed on an inner wall face of the tube housing, so as to limit a stroke of downward movement of the pressure-bearing member.

11. A power semiconductor device, comprising the crimping-type IGBT module according to any one of claims 1-10.

## Patentansprüche

1. Crimp-IGBT-Modul (100), umfassend eine Vielzahl von Untermodulen (1-6), die sich auf und ab relativ zu einem Rohrgehäuse (17, 18) bewegen können, worin jedes von den Untermodulen umfasst:
ein leitfähiges Substrat (12) und eine leitfähige Abdeckplatte (13), die im Rohrgehäuse aufgenommen werden können oder die sich jeweils aus einer unteren Fläche und einer oberen Fläche des Rohrgehäuses heraus erstrecken;
eine Vielzahl von Chips (14), die am leitfähigen Substrat nebeneinandergestellt und beabstandet sind;
ein drucktragendes Element (11), das im Rohrgehäuse aufgenommen werden kann oder das sich aus der unteren Fläche des Rohrgehäuses heraus erstreckt;
eine Bypass-Sammelschiene (15), die über den Chips angeordnet ist, und dessen ein oberer Abschnitt an einer oberen Fläche des drucktragenden Elementes anliegt; und
ein elastisches Element (16), das zwischen der Bypass-Sammelschiene und der leitfähigen Abdeckplatte angeordnet ist, worin
wenn eine Presspasskraft nicht größer ist als eine elastische Kraft, die vom elastischen Element bereitgestellt wird, die leitfähige Abdeckplatte sich aus der oberen Fläche des Rohrgehäuses heraus erstreckt, sowohl das leitfähige Substrat als auch das drucktragende Element sich aus der unteren Fläche des Rohrgehäuses heraus erstrecken, und eine untere Fläche des leitfähigen Substrats mit der unteren Fläche des drucktragenden Elementes bündig ist; und
wenn die Presspasskraft größer ist als die elastische Kraft, die vom elastischen Element bereitgestellt wird, sowohl die untere Fläche des leitfähigen Substrats und die untere Fläche des drucktragenden Elementes mit der unteren Fläche des Rohrgehäuses bündig sind, und eine obere Fläche der leitfähigen Abdeckplatte mit der oberen Fläche des Rohrgehäuses bündig ist.

2. Crimp-IGBT-Modul nach Anspruch 1, worin jedes von den Untermodulen ferner einen Pufferblock (19) umfasst, der zwischen einer Modulabdeckplatte und dem drucktragenden Element angeordnet ist, und worin der Pufferblock dazu eingerichtet ist, das drucktragende Element dann zu puffern, wenn das drucktragende Element sich nach oben relativ zum Rohrgehäuse bewegt.

3. Crimp-IGBT-Modul nach Anspruch 1 oder 2, worin jedes von den Untermodulen ferner ein leitfähiges Pufferpolster (20) umfasst, das zwischen den Chips und der Bypass-Sammelschiene angeordnet ist, und worin das leitfähige Pufferpolster dazu eingerichtet ist, die Zuverlässigkeit der elektrischen Leitfähigkeit zwischen den Chips und der Bypass-Sammelschiene sicherzustellen.

4. Crimp-IGBT-Modul nach Anspruch 3, worin ein Wärmeausdehnungskoeffizient des leitfähigen Pufferpolsters und ein Wärmeausdehnungskoeffizient des leitfähigen Substrats zu einem Wärmekoeffizienten der Chips passen, so dass ein Defekt, der an der Kontaktfläche dazwischen auftritt, vermieden wird.

5. Crimp-IGBT-Modul nach Anspruch 4, worin die Chips und das leitfähige Substrat, sowie die Chips und das leitfähige Pufferpolster durch Schweißen oder Silbersintern verbunden sind.

6. Crimp-IGBT-Modul nach Anspruch 5, worin das leitfähige Pufferpolster und das leitfähige Substrat beide aus Molybdän oder einer Molybdän-Kupfer-Legierung hergestellt sind.

7. Crimp-IGBT-Modul nach einem der Ansprüche 1-6, worin jedes von den Untermodulen ferner eine Gatterausgangssonde (21) umfasst, die dazu eingerichtet ist, Gattersignale aus der Vielzahl von Chips parallel auszugeben.

8. Crimp-IGBT-Modul nach einem der Ansprüche 1-7, worin jedes von den Untermodulen ferner einen Seitenrahmen (22) umfasst, dessen eine untere Fläche mit Rändern einer oberen Fläche des leitfähigen Substrats in abgedichteter Weise verbunden ist, so dass ein Hohlraum mit einem abgedichteten Bodenabschnitt und einem offenen oberen Abschnitt gebildet wird, und der Hohlraum mit Silikagel eingegossen ist, so dass ein Isolationsabstand zwischen dem leitfähigen Substrat und dem leitfähigen Pufferpolster gebildet wird.

9. Crimp-IGBT-Modul nach einem der Ansprüche 1-8, worin jedes von den Untermodulen ferner ein drucktragendes Polster (23) umfasst, das zwischen der Bypass-Sammelschiene und dem elastischen Element angeordnet ist, und worin das drucktragende Polster zum Puffern der Druckübertragung zwischen der Bypass-Sammelschiene und dem elastischen Element eingerichtet ist, so dass die Intensität des Kontaktdruckes zwischen den Chips einheitlich ist.

10. Crimp-IGBT-Modul nach einem der Ansprüche 1-9, worin ein erster Absatz an einer Außenwandfläche des drucktragenden Elementes ausgebildet ist, und ein zweiter Absatz, der zum ersten Absatz passend ist, an einer Innenwandfläche des Rohrgehäuses ausgebildet ist, so dass ein Hub der Abwärtsbewegung des drucktragenden Elementes begrenzt wird.

11. Leistungshalbleiterbauelement, umfassend das Crimp-IGBT-Modul nach einem der Ansprüche 1-10.

## Revendications

1. Module IGBT de type de sertissage (100), comprenant une pluralité de sous-modules (1-6) pouvant se déplacer vers le haut et vers le bas par rapport à un boîtier de tube (17, 18), dans lequel chacun des sous-modules comprend :
un substrat conducteur (12) et une plaque de couverture conductrice (13), qui peuvent être logés dans le boîtier de tube ou s'étendre respectivement hors d'une surface inférieure et d'une surface supérieure du boîtier de tube ;
une pluralité de puces (14), qui sont juxtaposées et espacées sur le substrat conducteur ;
un élément de support de pression (11), qui peut être logé dans le boîtier de tube ou s'étendre hors de la surface inférieure du boîtier de tube ;
une barre omnibus de dérivation (15), qui est disposée au-dessus des puces, et dont une partie supérieure vient en butée contre une surface supérieure de l'élément de support de pression ; et
un élément élastique (16), qui est disposé entre la barre omnibus de dérivation et la plaque de couverture conductrice ; dans lequel
lorsqu'une force d'ajustement à la presse n'est pas supérieure à une force élastique fournie par l'élément élastique, la plaque de couverture conductrice s'étend hors de la surface supérieure du boîtier de tube, à la fois le substrat conducteur et l'élément de support de pression s'étendent hors de la surface inférieure du boîtier de tube, et une surface inférieure du substrat conducteur affleure la surface inférieure de l'élément de support de pression ; et
lorsque la force d'ajustement par pression est supérieure à la force élastique fournie par l'élément élastique, à la fois la surface inférieure du substrat conducteur et la surface inférieure de l'élément de support de pression sont au même niveau que la surface inférieure du boîtier de tube, et une surface supérieure de la plaque de couverture conductrice est au même niveau que la surface supérieure du boîtier de tube.

2. Module IGBT de type de sertissage selon la revendication 1, dans lequel chacun des sous-modules comprend en outre un bloc tampon (19), qui est disposé entre une plaque de couvercle de module et l'élément de support de pression, et dans lequel le bloc tampon est configuré pour tamponner l'élément de support de pression lorsque l'élément de support de pression se déplace vers le haut par rapport au boîtier de tube.

3. Module IGBT de type de sertissage selon la revendication 1 ou 2, dans lequel chacun des sous-modules comprend en outre un patin tampon conducteur (20), qui est disposé entre les puces et la barre omnibus de dérivation, et dans lequel le patin tampon conducteur est configuré pour assurer la fiabilité de la conduction électrique entre les puces et la barre omnibus de dérivation.

4. Module IGBT de type de sertissage selon l'une quelconque des revendications 3, dans lequel un coefficient de dilatation thermique du patin tampon conducteur et un coefficient de dilatation thermique du substrat conducteur correspondent à un coefficient thermique des puces, de manière à éviter qu'un défaut ne se produise sur une surface de contact entre elles.

5. Module IGBT de type de sertissage selon l'une quelconque des revendications 4, dans lequel les puces et le substrat conducteur, ainsi que les puces et le patin tampon conducteur sont connectés au moyen d'une soudure ou d'un frittage d'argent.

6. Module IGBT de type de sertissage selon l'une quelconque des revendications 5, dans lequel le patin tampon conducteur et le substrat conducteur sont tous deux en molybdène ou en alliage molybdène-cuivre.

7. Module IGBT de type de sertissage selon l'une quelconque des revendications 1 à 6, dans lequel chacun des sous-modules comprend en outre une sonde de sortie de grille (21), qui est configurée pour sortir des signaux de grille de la pluralité de puces en parallèle.

8. Module IGBT de type de sertissage selon l'une quelconque des revendications 1 à 7, dans lequel chacun des sous-modules comprend en outre un cadre latéral (22), dont une face inférieure est connectée aux bords d'une surface supérieure du substrat conducteur de manière étanche, de manière à former une cavité avec une partie inférieure étanche et une partie supérieure ouverte, et la cavité est enrobée de gel de silice, de manière à former une distance d'isolation entre le substrat conducteur et le patin tampon conducteur.

9. Module IGBT de type de sertissage selon l'une quelconque des revendications 1 à 8, dans lequel chacun des sous-modules comprend en outre un patin de support de pression (23), qui est disposé entre la barre omnibus de dérivation et l'élément élastique, et dans lequel le patin de support de pression est configuré pour tamponner le transfert de pression entre la barre omnibus de dérivation et l'élément élastique, de sorte que l'intensité de la pression de contact entre les puces est cohérente.

10. Module IGBT de type de sertissage selon l'une quelconque des revendications 1 à 9, dans lequel une première marche est formée sur une face de paroi externe de l'élément de support de pression, et une seconde marche équipée de la première marche est formée sur une face de paroi interne du boîtier de tube, de manière à limiter une course de mouvement vers le bas de l'élément de support de pression.

11. Dispositif semi-conducteur de puissance, comprenant le module IGBT de type de sertissage selon l'une quelconque des revendications 1 à 10.
